# EUROPÄISCHE PATENTSCHRIFT

(11) **EP 2 787 357 B1**
(45) Veröffentlichungstag und Bekanntmachung des Hinweises auf die Patenterteilung: **07.08.2019**
(21) Anmeldenummer: 13162478.5
(22) Anmeldetag: 05.04.2013
(51) Int. Cl.: G01R 31/02

(54) **Verfahren und Vorrichtung zum Testen eines Transformators**
Method and device for testing a transformer
Procédé et dispositif de test d'un transformateur

(43) Veröffentlichungstag der Anmeldung: 08.10.2014
(73) Patentinhaber: Omicron electronics GmbH, 6833 Klaus (AT)
(72) Erfinder: Jäger, Markus, 6850 Dornbirn (AT); Krüger, Michael, 6844 Altach (AT); Atlas, Dmitry, 6833 Weiler (AT); Predl, Florian, 6840 Götzis (AT); Freiburg, Michael, 44135 Dortmund (DE)
(74) Vertreter: Banzer, Hans-Jörg

(56) Entgegenhaltungen:
- EP-A1- 1 398 644
- EP-A1- 1 653 238
- EP-A1- 2 466 322
- Omicron Electronics Gmbh: "CT Analyzer - Revolution in Current Transformer Testing and Calibration", , 1. Dezember 2012 (2012-12-01), Seiten 1-12, XP055080149, Gefunden im Internet: URL:https://www.omicron.at/fileadmin/user_ upload/pdf/literature/CT-Analyzer-Brochure -ENU.pdf [gefunden am 2013-09-19]

## Beschreibung

Die vorliegende Erfindung betrifft ein Verfahren und eine Vorrichtung zum Testen eines Transformators oder Messwandlers. Insbesondere betrifft die Erfindung ein Verfahren und eine Vorrichtung zum Testen der Genauigkeit von Spannungswandlern, ohne jedoch auf diesen bevorzugten Anwendungsbereich beschränkt zu sein.

Spannungswandler mit induktivem oder kapazitivem Wirkprinzip sind Betriebsmittel der Hochspannungstechnik und Bestandteil eines jeden Energieversorgungsnetzes. Beim induktiven Wirkprinzip handelt es sich im Wesentlichen um das Prinzip eines einphasigen Transformators, bei dem kapazitiven Wirkprinzip um eine Kombination aus kapazitivem Spannungsteiler, Drosselspule und einphasigem Transformator. Kapazitive Spannungswandler werden beispielsweise in Hoch- und Höchstspannungsnetzen mit sehr hohen Spannungen im Bereich von einigen hundert kV eingesetzt, wobei der kapazitive Spannungsteiler des Spannungswandlers dabei als Abwärtswandler dient, um die hohe Spannung in einen mittleren Spannungsbereich von einigen kV umzusetzen und mit dieser Spannung den Transformator zu speisen.

Spannungswandler dienen zum einen der Transformation der Betriebsspannungen in proportionale Spannungen, die sich informationstechnisch weiterverarbeiten lassen, zum anderen haben sie die Aufgabe der galvanischen Trennung von Hochspannung und Sekundärtechnik.

Die transformierten Spannungen der Wandler werden für Abrechnungs- oder Schutzzwecke weiter verwendet. Abhängig von diesem Einsatzgebiet (Abrechnung oder Schutz) müssen die Wandler eine gewisse Genauigkeitsklasse einhalten. Die Genauigkeitsklassen sind für induktive Wandler in der Norm DIN EN 60044-2 und für kapazitive Wandler in der Norm DIN EN 60044-5 definiert, wobei diese Normen aktuell von der Normenreihe DIN EN 61869 abgelöst werden.

Nach Norm sind Spannungswandler je nach Verwendungszweck in verschiedene Genauigkeitsklassen eingeteilt. Je nach Klasse dürfen Winkel und Amplitudenfehler der Übertragung einen bestimmten Wert nicht überschreiten. Die Wandler sind insbesondere in Klassen eingeteilt, die sich nach ihrer maximal zulässigen prozentualen Abweichung Spannungsmessabweichung bei Bemessungsspannung und Bemessungsbürde richten (beispielhafte Klassen sind: 0,1 - 0,2 - 0,5 - 1,0 - 3,0). Bei Wandlern für Messzwecke dürfen die genannten Klassen bei Betriebsfrequenz (50Hz bzw. 60Hz), Bemessungsbürde (z.B. im Bereich 25% bis 100%) mit einem Leistungsfaktor beispielsweise im Bereich 0,8 bis 1,0 induktiv und Spannungen von z.B. 80% bis 120% der Bemessungsspannung nicht verlassen werden. Bei Wandlern für Schutzzwecke müssen die Klassen bei Betriebsfrequenz, Bemessungsbürden (25% bis 100%) mit Leistungsfaktor 0,8 induktiv und Spannungen von 5% bis 190% (je nach Erdfehlerfaktor) der Bemessungsspannung eingehalten werden. Die zuvor genannten Klassen und Grenzwerte können länderspezifisch variieren, wobei von Kunden auch davon abweichende Werte gefordert werden können.

Bei Betrachtung der Genauigkeitsklassen lässt sich feststellen, dass es sich bei den Spannungswandlern um hochpräzise Messgeräte handeln muss, an die sowohl bezüglich des Spannungs-Übertragungsverhältnisses als auch bezüglich des Übertragungswinkels sehr hohe Genauigkeitsanforderungen gestellt werden. Ungenauigkeiten können durch Abweichungen der Messung der übertragenen Energie hohe Kosten verursachen oder einen sicheren Betrieb gefährden.

Um die Wandler auf ihre Genauigkeit zu prüfen, werden sie aktuell nach Bedarf demontiert, durch einen Ersatzwandler ersetzt und zur Genauigkeitsprüfung in ein Hochspannungslabor verfrachtet. Durch die aufwändigen Maßnahmen entstehen hohe Kosten, Ausfallzeiten und ein großer Prüf- und Montageaufwand. Zur Kompensation der Kosten und des Aufwands wurden in der Vergangenheit Prüflösungen entworfen, die vor Ort eine Prüfung bei Nennspannung erlauben und so den Montage- und Verfrachtungsaufwand minimieren.

Es existiert jedoch derzeit kein Verfahren, um die Wandler vor Ort auf deren Genauigkeit zu überprüfen, ohne nahezu die Nennspannung der Wandler als Prüfspannung zu verwenden. Die Nichtlinearität der Betriebsmittel erlaubt es nicht unmittelbar, eine Prüfung bei kleinen Spannungen durchzuführen.

Aus dem Bereich von Stromwandlern bekannte Verfahren können nicht vollständig auf Spannungswandler übertragen werden, da die Parameter des Wandlers aufgrund von parasitären Einflüssen und ihrem internen Aufbau nicht ohne weiteres ermittelt werden können. Zudem berücksichtigen die bereits bekannten Verfahren nicht das nicht-lineare frequenzabhängige Verhalten der Verlustausbreitung von Spannungswandlern.

Relevante Dokumente aus dem Stand der Technik sind EP1398644A1, "CT Analyzer - Revolution in Current Transformer Testing and Calibration" (Omicron Electronics Gmbh, XP055080149), EP2466322A1 und EP1653238A1.

Der vorliegenden Erfindung liegt daher die Aufgabe zugrunde, ein verbessertes Verfahren und eine entsprechend ausgestaltete Vorrichtung bereitzustellen, mit deren Hilfe Transformatoren oder Messwandler mit geringem Aufwand vor Ort hinsichtlich ihrer Genauigkeit überprüft werden können, wobei die Erfindung insbesondere zur Überprüfung von Spannungswandlern geeignet sein soll. Diese Aufgabe wird erfindungsgemäß durch ein Verfahren mit den Merkmalen des Anspruchs 1 und eine Vorrichtung mit den Merkmalen des Anspruchs 19 gelöst. Die abhängigen Ansprüche definieren bevorzugte und vorteilhafte Ausführungsformen der Erfindung.

Die Erfindung schlägt vor, den zu testenden Transformator durch ein Ersatzschaltbild abzubilden und automatisch durch Auswertung einer in Folge eines Testsignals erzeugten Testantwort des Transformators die Genauigkeit des Transformators bezogen auf das Ersatzschaltbild zu bestimmen. Die auf das Ersatzschaltbild bezogene Genauigkeit wird anschließend ebenfalls automatisch oder rechnergestützt in eine auf einen Betriebsfall bezogene Genauigkeit des Transformators umgesetzt.

Die vorliegende Erfindung gewährleistet eine autarke Überprüfung der Genauigkeit von Transformatoren allgemein, wobei eine genaue und reproduzierbare Approximation des Betriebszustands des Transformators über dessen Übertragungsverhalten bei kleinen Prüfspannungen möglich ist.

Die Erfindung lässt sich in Form eines tragbaren Testgeräts realisieren, so dass der Test des Transformators vor Ort (in-situ) erfolgen kann. Dabei ist die Erfindung insbesondere zum Testen von induktiven oder kapazitiven Spannungswandlern geeignet, wobei die Erfindung jedoch allgemein zum Überprüfen der Genauigkeit von Transformatoren eingesetzt werden kann.

Gemäß einer Ausführungsform der Erfindung wird ein Mess- und Berechnungsmodell angewendet, um aus Messergebnissen bei kleinen Messspannungen mit unterschiedlichen Frequenzen Aussagen auf das Verhalten im Betriebsfall abzuleiten. Als Grundlage dazu dient ein für diesen Betriebsfall ausgelegtes Ersatzschaltbild, dessen Elemente auf verschiedene Varianten bestimmt werden können. Sind alle Parameter des Ersatzschaltbilds bekannt, ist es auf Grundlage des Ersatzschaltbildes möglich, in Anlehnung an das Spannungszeigerdiagramm des Transformators das Verhalten des Transformators und dessen Genauigkeit in Betrag und Phase bei unterschiedlichen Betriebszuständen zu berechnen.

Gemäß einem weiteren Ausführungsbeispiel erlaubt es die Erfindung, mit kleinen Spannungen von der Niederspannungsseite des Transformators bei variabler Frequenz und einem entsprechenden Verlustinterpretations- und Berechnungsmodell alle nötigen Parameter des Transformators, das Übersetzungsverhältnis und die frequenzabhängigen linearen oder nicht-linearen Eisenverluste des Transformators zu ermitteln.

Gemäß einem weiteren Ausführungsbeispiel der Erfindung wird ein Ersatzschaltbild des Transformators verwendet, bei dem die komplexe und verteilte primäre Wicklungskapazität als konzentriertes Element berücksichtigt wird und ein neuartiges Verfahren zur Bestimmung der primären Wicklungskapazität und darauf aufbauend ein Verfahren zur Bestimmung der Leerlauf-Übersetzung des Transformators eingesetzt wird.

Gemäß einem bevorzugten Ausführungsbeispiel der Erfindung wird eine Windungskorrektur, die im Herstellungsprozess des Transformators zur Einhaltung der Genauigkeitsklasse durchgeführt worden sein kann, berücksichtigt.

In weiteren Ausführungsbeispielen der Erfindung können auch die folgenden Merkmale einzeln oder in Kombination realisiert sein:
- Bei kapazitiven Spannungswandlern kann zudem der kapazitive Spannungsteiler des Spannungswandlers hinsichtlich seiner Genauigkeit untersucht werden.
- Es kann ein Simulationsmodell der frequenz- und flussabhängigen Eisenverluste des Transformators verwendet werden, welches herkömmliche empirischanalytische Verlustmodelle um die Flussdichteabhängigkeit zu **P_{ges} = C · f^{x} · Ψ^{y}** reduziert. Dabei beschreiben C, f^{x}, und Ψ^{x} die vom Wandler sowie der Frequenz f und dem Fluss Ψ abhängigen Komponenten. Um diese Vereinfachung zu ermöglichen, werden Messungen mit unterschiedlichen Frequenzen jeweils für den gleichen verketteten Fluss durchgeführt. Mit einem modellbasierten Verfahren können schließlich der dynamische Koeffizient C sowie der Exponent x der Frequenz f und der Exponent y für den Fluss Ψ bestimmt werden. Zur Bedienung des Simulationsmodells werden Messungen vorzugsweise bei kleinen Spannungen kleiner 10V und variabler Frequenz zwischen 0 und 50Hz durchgeführt.
- Die konzentrierte primären Wicklungskapazität des Ersatzschaltbilds kann basierend auf Referenzmessungen mit einer genau bekannten Referenzkapazität bestimmt werden. Dazu wird ein Kleinsignal mit variabler Frequenz sekundärseitig an den Spannungswandler angelegt, um die erste Parallelresonanz zu finden. Mit Hilfe eine Referenzkapazität, welche hinzugeschaltet wird, wird dann diese Resonanzfrequenz gewollt verstimmt, um mit der Kenntnis der Referenzkapazität und der neu eingestellten Resonanz die primäre Wicklungskapazität zu bestimmen. Dieses Verfahren wird lediglich bei induktiven Spannungswandlern durchgeführt, da die Wicklungskapazität bei den in kapazitiven Spannungswandlern verwendeten induktiven Wandlern für den Frequenzbereich um 50Hz vernachlässigbar ist.
- Die Bestimmung der Wicklungswiderstände des Ersatzschaltbilds kann mit Gleichspannungssignalen erfolgen.
- Die Summe der Streuinduktivitäten des Ersatzschaltbilds kann auf Basis der ermittelten primären Wicklungskapazität oder auf Basis einer gemessenen Kurzschlussreaktanz bestimmt werden. Bei Transformatoren mit einer Wicklung kann eine Aufteilung der Streuinduktivitäten gemäß empirisch ermittelten Werden angenommen werden. Bei Transformatoren mit mehreren Wicklungen können die auf die jeweilige Seite bezogenen Streuinduktivitäten auf Basis gegenseitiger Messungen der einzelnen Wicklungen ermittelt werden.

Allgemein ermöglicht die Erfindung eine vollständige Aussage über die Genauigkeit des Transformators ohne Fingerprints und Kenntnisse über die eingesetzten Materialien und erlaubt in Anlehnung an die Normenreihe DIN EN 60044 oder aktuell DIN EN 61869 die Berücksichtigung einer variablen Bürde mit unterschiedlichen Leistungsfaktoren und unterschiedlichen Betriebsspannungen.

Die Erfindung wird nachfolgend näher unter Bezugnahme auf bevorzugte Ausführungsbeispiele anhand der beigefügten Zeichnung erläutert.
Fig. 1 zeigt den Aufbau eines Transformators in Form eines kapazitiv gekoppelten Spannungswandlers und ein entsprechendes Ersatzschaltbild.
Fig. 2 zeigt ein vereinfachtes schematisches Blockschaltbild einer Testvorrichtung zum Testen eines Transformators gemäß einer Ausführungsform der Erfindung.
Fig. 3 zeigt eine beispielhafte Ankopplung und Verschaltung der Testvorrichtung mit dem in Fig. 1 gezeigten kapazitiv gekoppelten Spannungswandler zum Testen des Spannungswandlers, insbesondere zum Testen des Gesamtübersetzungsverhältnisses des Spannungswandlers.
Fig. 4 zeigt eine beispielhafte Verschaltung der Testvorrichtung mit dem Spannungswandler von Fig. 1 zum Testen des Übersetzungsverhältnisses des induktiven Spannungswandlerabschnitts des Wandlers und zum Testen des kapazitiven Spannungsteilers des Wandlers.
Fig. 5 zeigt ein Flussdiagramm zur Erläuterung des Ablaufs eines Verfahrens zum Testen der Genauigkeit von Transformatoren gemäß einem Ausführungsbeispiel der Erfindung.
Fig. 6 zeigt ein Flussdiagramm zur Bestimmung der Hauptinduktivität und des Verlustwiderstands des in Fig. 1 gezeigten Ersatzschaltbilds unter Anwendung eines ferromagnetischen Verlustmodells gemäß einem Ausführungsbeispiel der Erfindung.
Fig. 7 zeigt ein Flussdiagramm zur Bestimmung der Hauptinduktivität und des Verlustwiderstands des in Fig. 1 gezeigten Ersatzschaltbilds unter Anwendung eines ferromagnetischen Verlustmodells gemäß einem weiteren Ausführungsbeispiel der Erfindung.

Die Erfindung wird nachfolgend anhand eines kapazitiv gekoppelten Spannungswandlers erläutert, wobei die Erfindung jedoch nicht auf diese Anwendung beschränkt ist, sondern ebenso auf induktive Spannungswandler sowie allgemein auf Transformatoren und Messwandler angewendet werden kann.

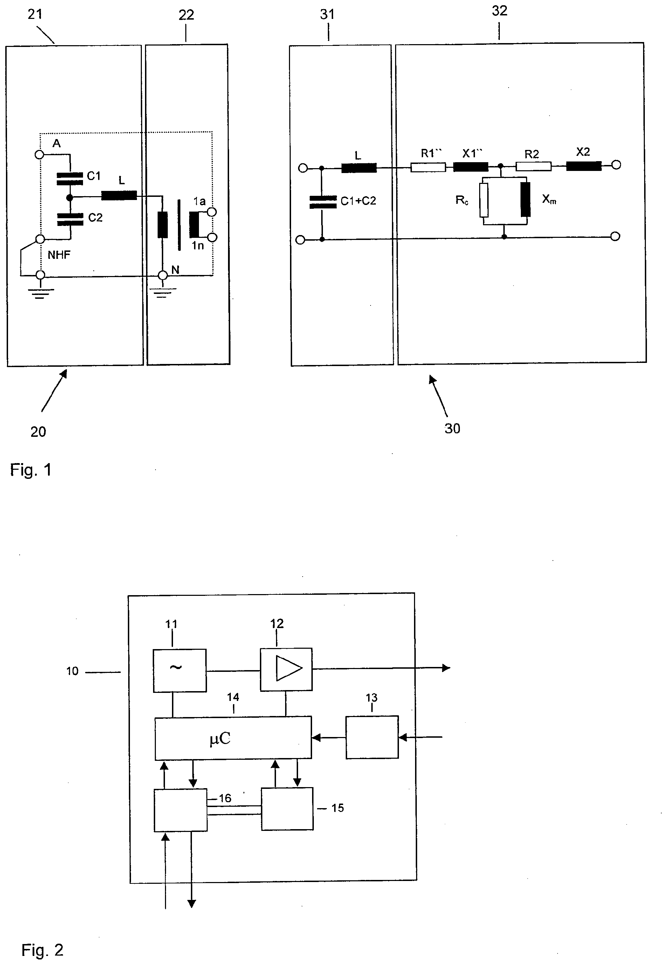

In Fig. 1 ist die Struktur eines derartigen kapazitiv gekoppelten Spannungswandlers 20 dargestellt, wobei der Spannungswandler 20 einen Kopplungsabschnitt 21 mit Kopplungskapazitäten C1 und C2, welche einen kapazitiven Spannungsteiler bilden, und einer auf die Kapazitäten C1 und C2 abgeglichenen Drosselspule L sowie einen (induktiven) Transformatorabschnitt 22 mit einem einphasigen Transformator umfasst. Die primärseitigen Anschlüsse des Spannungswandlers 20 sind mit A bzw. NHF bezeichnet, während die sekundärseitigen Anschlüssen mit 1a und 1n bezeichnet sind. Der Übersichtlichkeit halber ist in Fig. 1 ein Spannungswandler bzw. Transformator mit lediglich einer Sekundärwicklung dargestellt.

Im Rahmen der vorliegenden Erfindung wird der Transformator bzw. Spannungswandler durch ein Ersatzschaltbild nachgebildet, wobei das Ersatzschaltbild wahlweise auf die Primärseite oder auf die Sekundärseite des Spannungswandlers bezogen sein kann.

Ein derartiges Ersatzschaltbild 30 ist beispielhaft ebenfalls in Fig. 1 dargestellt, wobei ein Abschnitt 31 des Ersatzschaltbilds dem Kopplungsabschnitt 21 des Spannungswandlers 20 zugeordnet ist, während ein Abschnitt 32 des Ersatzschaltbilds dem Transformatorabschnitt 22 des Spannungswandlers 20 entspricht.

In Fig. 2 ist ein Blockschaltbild einer Testvorrichtung 10 gemäß einem Ausführungsbeispiel der Erfindung dargestellt, welche auf Grundlage eines derartigen Ersatzschaltbildes mittels automatischer Abläufe die Genauigkeit des Spannungswandlers überprüft und hierzu durch Anlegen einer Summe von Testsignalen und Durchführen von verschiedenen nachfolgend näher erläuterten Messungen die einzelnen Komponenten bzw. Parameter des Ersatzschaltbilds ermittelt, um anschließend auf dieser Basis zunächst die Genauigkeit des Spannungswandlers bezogen auf das Ersatzschaltbild zu bestimmen und die auf das Ersatzschaltbild bezogene Genauigkeit in eine auf einen Betriebsfall bezogene Genauigkeit umzusetzen.

Die in Fig. 2 schematisch dargestellte Testvorrichtung 10 umfasst eine Signalquelle 11 zur Erzeugung eines Test- oder Messsignals bestimmter Amplitude und Frequenz sowie einen steuerbaren Verstärker 12, über den das auf gewünschte Art und Weise verstärkte Testsignal an den Prüfling ausgegeben wird. Die Testvorrichtung kann über separate Ausgänge für einen Niedrigspannung-Test einerseits und einen Hochspannung-Test andererseits verfügen. Die Ansteuerung der Signalquelle 11 und des steuerbaren Verstärkers 12 erfolgt über eine Steuereinheit 14, welche in Form eines Mikrocontrollers oder digitalen Signalprozessors ausgestaltet sein kann. Die sich am Testobjekt oder Prüfling daraufhin einstellende Testantwort wird von einer Mess- oder Erfassungseinrichtung 13 erfasst und der Steuereinheit 14 zugeführt, welche die Testantwort auswertet und abhängig davon weitere Aktionen einleitet.

Die Steuereinheit 14 ist die zentrale Komponente der Testvorrichtung 10 und ist für den weitgehend automatischen Ablauf des nachfolgend anhand eines bevorzugten Ausführungsbeispiels erläuterten Testverfahrens verantwortlich. Wie in Fig. 2 gezeigt ist, verfügt die Testvorrichtung 10 über einen Speicher 15 zum Speichern von Betriebs- bzw. Steuerprogrammen für die Steuereinheit 14 oder zum Speichern von Testergebnissen etc. Über einen Eingabe-/Ausgabeabschnitt 16 können Befehle oder Steuerinformation dem Testgerät 10 zugeführt oder Testergebnisse bzw. Steuerinformationen für andere Geräte ausgegeben werden. Dieser Eingabe-/Ausgabeabschnitt kann beispielsweise eine Tastatur, eine Anzeige und verschiedene Arten von Schnittstellen (USB, D-Sub 9, Flash-Karten-Slots etc.) umfassen. Ebenso kann die Testvorrichtung über einen Potentialausgleichanschluss verfügen.

Die Testvorrichtung 10 ist vorzugsweise in Form eines kompakten tragbaren Geräts ausgestaltet, so dass mit Hilfe dieses Geräts ein Transformator vor Ort auf einfache Weise geprüft werden kann. Wie nachfolgend noch näher erläutert wird, kann die Testvorrichtung 10 zur Durchführung bestimmter Messungen mit einem Spannungsbooster gekoppelt werden, welcher die von dem Testgerät gelieferte Testspannung auf einen gewünschten hohen Spannungswert verstärkt und an das Testobjekt anlegt.

Die Steuereinheit 14 der Testvorrichtung 10 ist derart ausgestaltet, dass sie mit Hilfe mehrerer automatisch ablaufender Messungen die einzelnen Komponenten des in Fig. 1 beispielhaft gezeigten Ersatzschaltbilds bestimmt und anhand des somit bekannten Ersatzschaltbilds die auf das Ersatzschaltbild bezogene Genauigkeit des Spannungswandlers ermittelt. Der Anschluss der Testvorrichtung 10 an den Spannungswandler 20 kann dabei gemäß einem Vierdraht-Messverfahren erfolgen, wobei die direkt am Testobjekt angelegte Spannung zurückgemessen wird, um zu vermeiden, dass Kabel oder Übergangswiderstände an den Klemmen die Messung beeinflussen.

Die auf das Ersatzschaltbild bezogene Genauigkeit wird von der Steuereinheit 14 anschließend in eine auf einen Betriebsfall bezogene Genauigkeit umgesetzt, um eine Bewertung des Spannungswandlers sowohl hinsichtlich Amplitudengenauigkeit als auch hinsichtlich Phasengenauigkeit zu ermöglichen.

Zur Bestimmung der Komponenten des Ersatzschaltbilds werden gemäß einem Ausführungsbeispiel der Erfindung insbesondere die folgenden nachfolgend näher erläuterten Messungen durchgeführt: Primäre und sekundäre Kurzschluss-Impedanzmessungen, Messung des Widerstands der Sekundärwicklungen des Spannungswandlers, Messung des Magnetisierungsverhaltens des Spannungswandlers, Messung des Übersetzungsverhältnisses des Spannungswandlers.

Der DC-Wicklungswiderstand wird für jede Sekundärwicklung des Spannungswandlers 20 ermittelt, so dass aus der Testantwort des Spannungswandlers 20 die Information über den jeweiligen Sekundärwicklungswiderstand R2 des Ersatzschaltbilds 30 bekannt ist (vgl. Fig. 1). Die Messung erfolgt vorzugsweise in der Reihenfolge von der höchsten Wicklung zur niedrigsten Wicklung, um den Verdrahtungsaufwand zu reduzieren. Der transformierte Primärwicklungswiderstand R1" des Ersatzschaltbilds 30 kann aus ebenfalls gemessenen Streuverlusten und den DC-Sekundärwiderstandswerten berechnet werden.

Die Kurzschlussimpedanzmessungen können von der Testvorrichtung 10 sowohl primärseitig als auch sekundärseitig durchgeführt werden.

Bei der primärseitigen Kurzschlussimpedanzmessung werden die Eingangsanschlüsse A und NHF des Spannungswandlers 20 kurzgeschlossen und auf Erdpotential gelegt, und es wird ein Testsignal an den Spannungswandler angelegt, um nacheinander an jeder Sekundärwicklung die Testantwort zu erfassen und anhand der Testantwort des Spannungswandlers 20 die bereits zuvor erwähnten Streuverluste bestimmen zu können. Sind mehrere Sekundärwicklungen vorhanden, wird diese Messung für jede Sekundärwicklung separat durchgeführt.

Die sekundärseitige Kurzschlussimpedanzmessung wird nur für eine Sekundärwicklung durchgeführt, d.h. es wird beispielsweise lediglich die zweite Sekundärwicklung 2a-2n des Spannungswandlers 20 kurzgeschlossen und die Kurzschlussimpedanz an der ersten Sekundärwicklung 1a-1n gemessen (verfügt der Spannungswandler über lediglich eine Sekundärwicklung, ist keine sekundärseitige Kurzschlussimpedanzmessung erforderlich).

Dies ermöglicht insgesamt, dass für das in Fig. 1 gezeigte Ersatzschaltbild die transformierte Primärstreuinduktivität X1" und die Sekundärstreuinduktivität X2 separat für jede Sekundärwicklung bestimmt werden können.

Die Messung des Magnetisierungsverhaltens des Spannungswandlers muss an sich nur für eine Sekundärwicklung, beispielsweise für die innerste Sekundärwicklung 1a-1n, durchgeführt werden, da der Eisenkern des Spannungswandlers für alle Sekundärwicklungen der gleiche ist und die Streuverluste dieser Sekundärwicklung bekannt sind, um die EMF-Spannung entsprechend berechnen zu können. Dennoch können auch mehrere derartige Messungen durchgeführt werden.

Die Messung des Übersetzungsverhältnisses des Spannungswandlers 20 wird von der Testvorrichtung 10 durchgeführt, um das tatsächliche Wicklungs- oder Windungsverhältnis des Spannungswandlers 20 zu bestimmen und dabei insbesondere eine während des Herstellungsprozesses vorgenommene Windungskorrektur zu berücksichtigen.

Ein Spannungswandler wird grundsätzlich beim Hersteller im Entwicklungsprozess berechnet, ehe der Spannungswandler in Serie produziert wird. Diese Berechnung erfolgt auf "konstanten" Grundwerten der einzusetzenden Materialien und meistens auch unter Berücksichtigung der Toleranzen im Fertigungsprozess. Sowohl die Toleranzen der eingesetzten Materialien als auch die Toleranzen der Fertigungsprozesse beeinflussen letztendlich die Genauigkeit des fertigen Produkts. Daher wird während des Fertigungsprozesses gewöhnlich nach dem Anbringen der Wicklungen und vor der Isolierung eine Kontrollmessung durchgeführt, um festzustellen, ob sich der Spannungswandler im gewohnten Arbeitsbereich befindet. Sollten Abweichungen vorliegen, wird der Spannungswandler über ein Verändern der Windungsanzahl auf den gewünschten Bereich "abgeglichen". Aufgrund dieser Windungskorrektur stimmt das reine Wicklungsübersetzungsverhältnis des Spannungswandlers dann nicht mehr mit dem nominalen Spannungsübersetzungsverhältnis überein.

Wie bereits zuvor erläutert worden ist, erfasst die Testvorrichtung 10 allgemein die Verluste des zu prüfenden Spannungswandlers 20, um dessen "Genauigkeit" zu bestimmen bzw. zu berechnen. Zu diesen Verlusten muss somit auch eine derartige im Herstellungsprozess des Spannungswandlers 20 vorgenommene Windungskorrektur erfasst werden, damit die absolute Genauigkeit des Spannungswandlers 20 bestimmt werden kann. Aus diesem Grund ist die Testvorrichtung 10 zur Durchführung einer Messung des Übersetzungsverhältnisses des Spannungswandlers 20 ausgestaltet, wobei hierzu eine Testspannung an die Primärseite des zu prüfenden Spannungswandlers 20 angelegt wird.

Zur Messung der Übersetzung ist es wichtig dass diese mit einer Spannung ausgeführt wird, welche nicht allzu gering ist im Vergleich zur primären Nennspannung des Testobjekts. Als geeignet haben sich Spannungen erwiesen, welche ca. 3% bis 80% der Nennspannung betragen.

Da das Testgerät 10 zur Durchführung der anderen zuvor beschrieben Messungen mit geringen Spannungen, vorzugsweise in der Größenordnung von maximal 10V bzw. 40V Effektivwert, arbeitet und demzufolge die Spannungsquelle 11 der Testvorrichtung 10 entsprechend für kleiner Spannungen ausgelegt ist, ist zur Durchführung der Übersetzungsverhältnismessung der Einsatz einer entsprechenden Verstärkeranordnung in Form eines Spannungsboosters erforderlich. Eine derartige Verstärkeranordnung kann auch in die Testvorrichtung 10 integriert sei, was jedoch das Gewicht und die Größe der Testvorrichtung entsprechend vergrößern würde. Die Verwendung einer separaten Verstärkeranordnung kann aufgrund der auftretenden hohen Spannungen auch aus Sicherheitsgründen vorteilhaft sein. Werden unterschiedliche Spannungsvarianten benötigt, kann es ebenfalls vorteilhaft sein, mit verschiedenen Komponenten zu arbeiten.

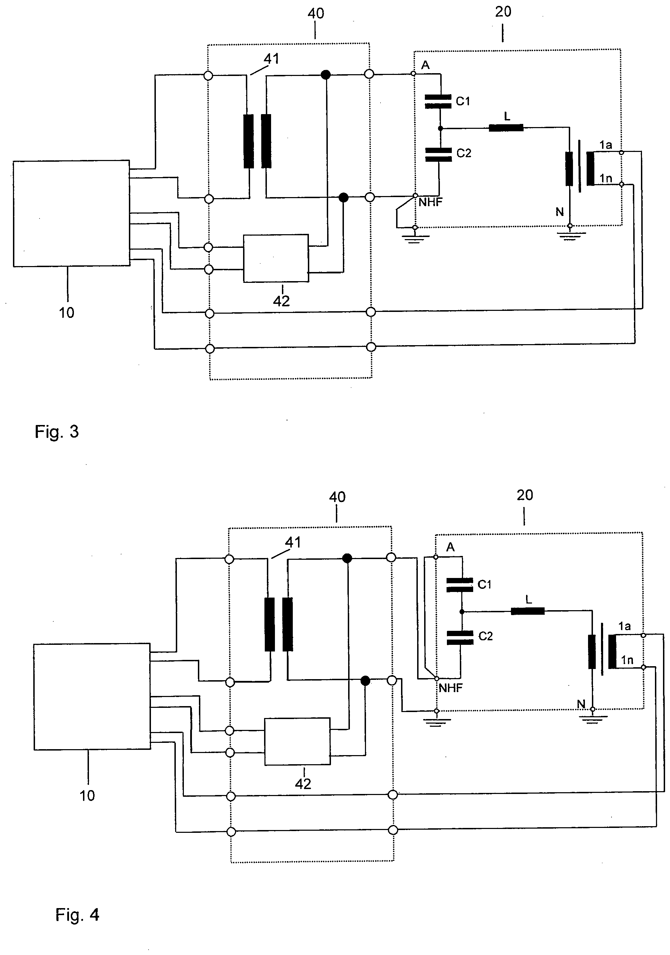

Eine beispielhafte Verschaltung der Testvorrichtung 10 mit einem Spannungsbooster 40 und dem in Fig. 1 gezeigten Spannungswandler 20 ist in Fig. 3 dargestellt.

Testsignalausgänge der Testvorrichtung 10 sind mit der Primärseite eines Transformators 41 des Spannungsboosters 40 gekoppelt , während primäre und sekundäre Testantwort-Messeingänge der Testvorrichtung 10 über einen Spannungsteiler 42 mit der Sekundärseite des Transformators 41 und der Primärseite des Spannungswandlers 20 bzw. mit der Sekundärseite des Spannungswandlers 20 gekoppelt sind. Der Anschluss der Testvorrichtung an den Spannungswandler erfolgt dabei gemäß einem Vierdraht-Messverfahren, wobei die direkt am Testobjekt angelegte Spannung zurückgemessen wird, um zu vermeiden, dass Kabel oder Übergangswiderstände an den Klemmen die Messung beeinflussen.

Mit der in Fig. 3 gezeigten Anordnung kann das Gesamtübersetzungsverhältnis des Spannungswandlers 20 gemessen werden. Die Anschlüsse NHF und N des Spannungswandlers 20 sind mit Masse verbunden. Die von dem Spannungsbooster 40 gelieferte hohe Testspannung ist zwischen die Anschlüsse A und NHF und somit zwischen A und Masse angelegt. Der Niederspannungs-Messeingang der Testvorrichtung 10 ist mit der Sekundärwicklung 1a-1n des Spannungswandlers 20 verbunden.

Die Messung des Gesamtübersetzungsverhältnisses des Spannungswandlers 20 mit der in Fig. 3 gezeigten Anordnung wird auch bei Vorhandensein mehrerer Sekundärwicklungen vorzugsweise lediglich einmal für die erste Sekundärwicklung 1a-1n durchgeführt. Zudem wird die Messung des Gesamtübersetzungsverhältnisses nur für kapazitiv gekoppelte Spannungswandler durchgeführt, während bei induktiven Spannungswandlern auf diesen Test verzichtet werden kann. Als Ergebnis dieser Messung wird das Gesamtübersetzungsverhältnis in Form des Verhältnisses der Spannung an den Anschlüssen A und NHF zu der Spannung an der Sekundärwicklung 1a-1n des Spannungswandlers 20 bestimmt.

Mit einer geringfügig abgewandelten Testanordnung, welche in Fig. 4 dargestellt ist, kann die Übersetzung des induktiven Spannungswandlerabschnitts des Spannungswandlers 20 bestimmt werden. Der Zweck dieser Messung ist es insbesondere, zwischen kapazitivem Übersetzungsverhältnis und induktivem Übersetzungsverhältnis unterscheiden zu können.

Wie in Fig. 4 gezeigt ist, ist zu diesem Zweck der Anschluss NHF mit dem Hochspannungsanschluss A des Spannungswandlers 20 verbunden, wobei die Testspannung zwischen diesen beiden Anschlüsse und Masse angelegt wird. Ansonsten ist die Verschaltung ähnlich zu der in Fig. 3 gezeigten Testanordnung. Die an die Primärseite des Spannungswandlers angelegte Spannung wird vorzugsweise derart eingestellt, dass die Spannung an der Sekundärwicklung 1a-1n der mit der Messanordnung von Fig. 3 gemessenen Spannung entspricht. Als Ergebnis dieser Messung wird die Übersetzung des induktiven Spannungswandlers, d.h. ohne den kapazitiven Spannungsteiler C1, C2, in Form des Verhältnisses der Spannung an der Primärseite des induktiven Wandlers zu der Spannung an den Sekundärklemmen 1a-1n bestimmt.

Auch diese Messung wird vorzugsweise lediglich einmal für die erste Sekundärwicklung 1a-1n durchgeführt. Wird diese Messung für einen induktiven Spannungswandler durchgeführt, würde das Messergebnis unmittelbar dem Übersetzungsverhältnis des induktiven Spannungswandlers unter Leerlaufbedingungen entsprechen.

Aus den gemäß Fig. 3 und Fig. 4 erhaltenen Messergebnisses kann schließlich auch das Übersetzungsverhältnis des kapazitiven Spannungsteilers C1, C2 des Spannungswandlers 20 berechnet werden, indem die aus der Messung von Fig. 3 erhaltene Spannung zwischen den Anschlüssen A und NHF des Spannungswandlers 20 durch die aus der Messung von Fig. 4 erhaltene Spannung an der Primärseite des Wandlers bei kurzgeschlossenen Klemmen A-NHF dividiert wird.

Die zuvor beschriebenen Messungen werden von der Testvorrichtung 10 durchgeführt, um auf Grundlage der Somit gewonnenen Infomationen schlussendlich die Genauigkeit des geprüften Spannungswandlers 20 bestimmen zu können.

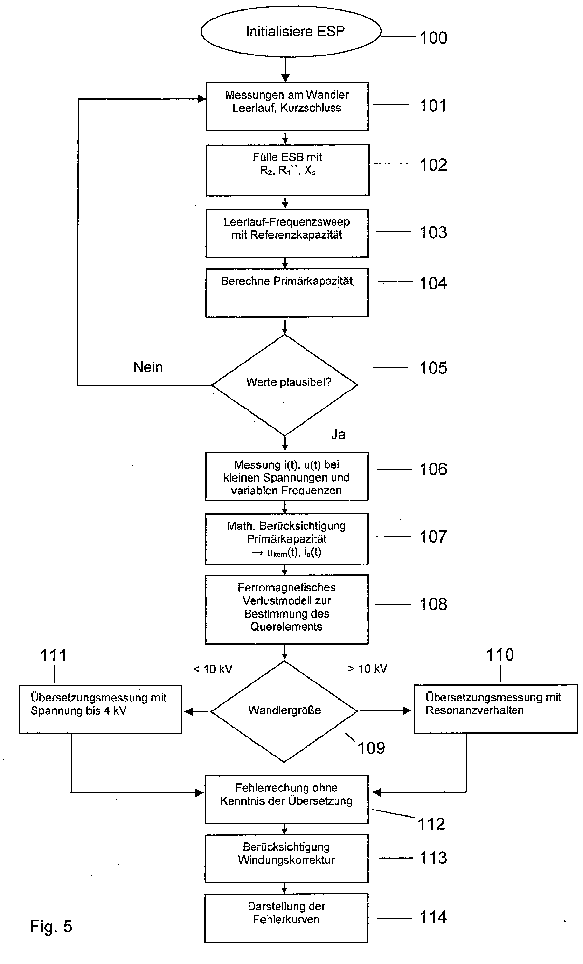

Fig. 5 zeigt in Form eines Flussdiagramms einen möglichen Ablauf des in der Testvorrichtung 10 unter Steuerung durch die Steuereinheit 14 automatisch ablaufenden Verfahrens zur Bestimmung der Genauigkeitsklasse induktiver Spannungswandler gemäß einem Ausführungsbeispiel der vorliegenden Erfindung. Auf zusätzlich zu berücksichtigenden Punkte bei Anwendung dieses Verfahrens auf kapazitiv gekoppelte Spannungswandler wird nachfolgend separat hingewiesen.

Als Grundlage dieses Verfahrens dient das bereits beschriebene Transformator-Ersatzschaltbild (ESB), welches auf die Sekundärseite des zu prüfenden Spannungswandlers bezogen sein kann (Schritt 100). Somit gewährleistet eine sekundärseitige Messung eine direkte Korrespondenz zum Ersatzschaltbild. Die im Ersatzschaltbild integrierte konzentrierte Kapazität stellt die für die hier relevanten Frequenzen bis 50Hz bzw. 60Hz zu berücksichtigende Wicklungskapazität dar (bei bestimmten Wandlertypen ist die Wicklungskapazität vernachlässigbar). Eine weitere Eigenschaft dieses Verfahrens ist die Tatsache, dass das Querelement, welches aus der Hauptinduktivität Xₘ und dem Verlustwiderstand R_{c} besteht, zunächst als unbekannt angenommen wird.

Zur Bestimmung der Elemente des Ersatzschaltbilds werden die zuvor beschriebenen Leerlauf- und Kurzschlussversuch durchgeführt (Schritt 101), um das Ersatzschaltbild mit den somit gewonnen Informationen zu belegen (Schritt 102).

Mit einem Frequenzsweep bei zugeschalteter Referenzkapazität (Schritt 103) lässt sich anschließend der Wert der primären Wicklungskapazität Cp bestimmen (Schritt 104). Die Schritte 103 und 104 zur Bestimmung der primären Wicklungskapazität Cp werden vorzugsweise nur durchgeführt, wenn die primäre Wicklungskapazität relativ hoch ist und daher der Einfluss der primären Wicklungskapazität berücksichtigt werden muss.

Sollten die gewonnnen Werte nicht plausibel sein (Schritt 105), werden die Messungen und demzufolge die Schritte 101-105 wiederholt.

Sollten die Werte hingegen plausibel sein, so kann das Magnetisierungsverhalten des Spannungswandlers von der Sekundärseite gemessen werden. Dazu wird für jeden denkbaren Betriebsfall der Aussteuerung sowohl der Strom i(t) als auch die Spannung u(t) und zeitaufgelöst gemessen (Schritt 106), wobei vorzugsweise lediglich Spannungen von bis zu 10 V verwendet werden. Mit Variation der Frequenz bei gleicher Amplitude kann der Fluss entsprechend der Vorgaben eingestellt werden.

Im Anschluss an die Messung des Magnetisierungsverhaltens wird der Einfluss der bereits berechneten primären Wicklungskapazität berücksichtigt (Schritt 107). Der kapazitive Strom wird vom Klemmenstrom subtrahiert, so dass lediglich die für die Magnetisierung des Kerns zuständige Stromkomponente i₀(t) und die am Kern anliegende Spannung uₖₑᵣₙ(t) weiter berücksichtigt wird.

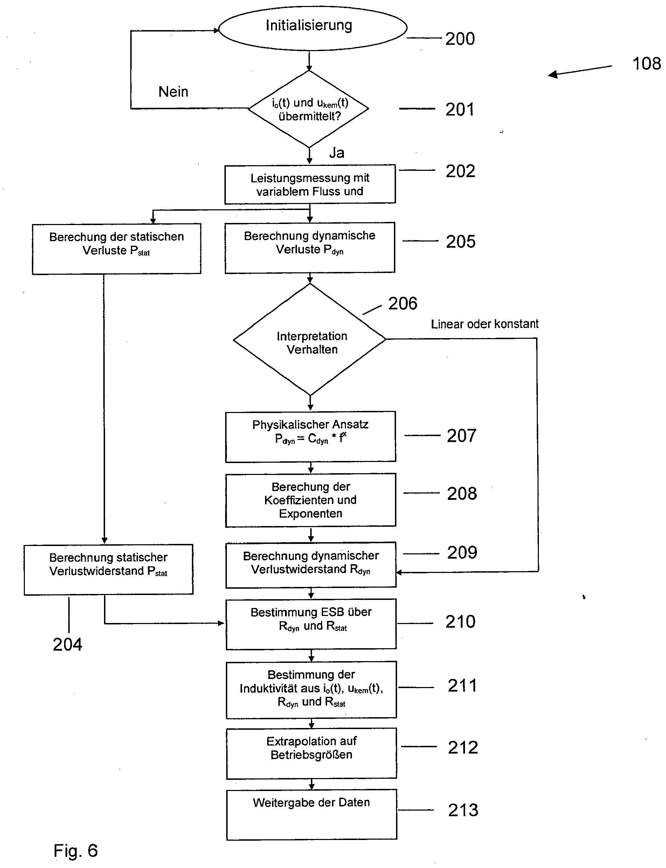

Da für die Messungen Frequenzen ungleich der Betriebsfrequenz verwendet werden, der Wandlerkern jedoch ein stark frequenzabhängiges Verhalten aufweist, werden die gemessenen Werte u(t) und i(t) in Werte, welche auf den Betriebsfall bezogen sind, umgesetzt. Hierzu dient ein umfangreiches ferromagnetisches Verlustinterpretations-und Verlustberechnungsmodell (Schritt 108), welches eigenständig weiter unten anhand von Fig. 6 beschrieben wird. Vom Verlust-Interpretationsmodell werden schließlich die Strom- und Spannungswerte in Netzwerkelemente transformiert. Die simulierten Werte der Magnetisierungskurve (Strom-Spannungs-Kennlinie) bei Betriebsfrequenz sowie die Winkelinformation bei unterschiedlichen Spannungen werden zurückgegeben. Nun kann für jede beliebige Bürde und Betriebsspannung die darauf bezogene Spannungsabweichung und Fehlwinkel bzw. Phasenfehler des Messwandlers in Anlehnung an das Spannungszeigerdiagramm berechnet werden.

Um aus dieser auf das Ersatzschaltbild "bezogenen Genauigkeit" des Spannungswandlers die wirkliche Genauigkeit im Betriebsfall zu berechnen, ist wie beschrieben die Leerlaufübersetzung des Spannungswandlers sehr genau zu messen. Diese weicht in der Regel von der nominalen Übersetzung ab, da zum einen der bürdenabhängige Spannungsabfall über die Sekundärimpedanz des Spannungswandlers als auch ein bei der Produktion eventuell durchgeführter Windungsabgleich berücksichtigt werden muss. Die Berücksichtigung des Windungsabgleichs wird hier als "Windungskorrektur" bezeichnet. Die Windungskorrektur kann abhängig von der physikalischen Auslegung des Spannungswandlers (Schritt 109) auf zwei unterschiedliche Varianten erfolgen. Zum einen kann wie beschrieben eine Hochspannung an die Primärseite des Spannungswandlers angelegt werden (Schritt 111). Die sekundärseitige Messung erlaubt dann für die explizite Spannung die Messung der Windungskorrektur. Eine zweite und universelle Lösung zur Berücksichtigung dieser Windungskorrektur bietet eine sekundärseitige Resonanzmessung in Verbindung mit den Werten der bereits im Vorfeld ermittelten Wicklungskapazität und Streuinduktivität (Schritt 110). Die in Fig. 5 angegebenen Spannungswerte sind lediglich beispielhaft zu verstehen.

Die zunächst ohne Kenntnis der tatsächlichen Übersetzung des Spannungswandlers ermittelte Messabweichung (Schritt 112) kann nun durch Berücksichtigung der Windungskorrektur korrigiert werden (Schritt 113), so dass schließlich Fehlerkurven für die Messabweichung in Betrag und Phase bezogen auf den Betriebsfall ausgegeben werden (Schritt 114).

Nachfolgend wird unter Bezugnahme auf Fig. 6 ein Verfahren zur Bestimmung der Hauptinduktivität und des Verlustwiderstands des Ersatzschaltbilds unter Anwendung des bereits erwähnten ferromagnetischen Verlustmodells (vgl. Schritt 108 in Fig. 5) gemäß einem Ausführungsbeispiel der Erfindung erläutert.

Spannungswandler haben aufgrund der verwendeten Kernmaterialien ein deutlich frequenz- und polarisationsabhängiges Verlustverhalten. Je nach Aussteuerung der Kernbleche ist dieses Verhalten mehr oder weniger nicht-linear. Es stellt sich je nach Induktionsrate und Induktionsamplitude eine feldstärkeabhängige Anordnung der Domänenstruktur und somit eine feldstärkeabhängige Polarisation bzw. Flussdichte ein, mit der eine nichtlineare Verlustausbreitung in Form von joulescher Wärme einhergeht. Wenn also ein Messsignal mit einer von der Betriebsfrequenz abweichenden Frequenz verwendet wird, ist es empfehlenswert, mit Hilfe eines Modells die frequenzabhängige Verlustausbreitung zu kompensieren.

Hierzu kann ein Simulationsmodell der frequenz- und flussabhängigen Eisenverluste des Transformators verwendet werden, welches herkömmliche empirisch-analytische Verlustmodelle um die Flussdichteabhängigkeit zu **P_{ges} = C · f^{x} · Ψ^{y}** reduziert. Dabei beschreiben C, f^{x}, und Ψ^{y} die vom Wandler sowie der Frequenz f und dem Fluss Ψ abhängigen Komponenten. Um diese Vereinfachung zu ermöglichen, werden Messungen mit unterschiedlichen Frequenzen jeweils für den gleichen verketteten Fluss durchgeführt. Mit einem modellbasierten Verfahren können schließlich der dynamische Koeffizient C sowie der Exponent x der Frequenz f und der Exponent y für den Fluss Ψ bestimmt werden. Zur Bedienung des Simulationsmodells werden Messungen vorzugsweise bei kleinen Spannungen kleiner 10V und variabler Frequenz zwischen 0 und 50Hz durchgeführt.

Fig. 6 zeigt ein Flussdiagramm zur Bestimmung der Hauptinduktivität und des Verlustwiderstands des in Fig. 1 gezeigten Ersatzschaltbilds unter Anwendung eines derartigen ferromagnetischen Verlustmodells oder Simulationsmodells gemäß einem Ausführungsbeispiel der Erfindung.

Zu Beginn des Verfahrens (Schritt 200) werden dem Verlustmodell zunächst die bereits um den kapazitiven Strom durch die primäre Wicklungskapazität korrigierten Stromwerte i₀(t) und die zugehörigen Spannungswerte uₖₑᵣₙ(t) übergeben (Schritt 201). Es folgen niederfrequente Leistungsmessungen bei den für den Betrieb üblichen Flussdichten (Schritt 202). Die niedrige Messfrequenz geht mit der Forderung kleiner Spannungsamplituden einher.

Die bei den Leistungsmessungen auftretenden Verluste P_{ges} werden mit einem Verlust-Separationsansatz in statische Verluste Pₛₜₐₜ und dynamische Verluste P_{dyn} getrennt. Die statischen Verluste Pₛₜₐₜ steigen linear mit der Frequenz (Schritt 203). Aus der statischen Komponente kann direkt der statische Verlustwiderstand Rₛₜₐₜ für das Netzwerkmodell berechnet werden (Schritt 204)

Das dynamische Verhalten der Verlustausbreitung mit der Frequenz wird anschließend interpretiert (Schritt 206). Dieses kann je nach Wandlertyp über die Frequenz konstant, linear oder nicht-linear sein. Für einen der ersten beiden Fälle kann direkt der dynamische Verlustwiderstand R_{dyn} berechnet werden. Da im nicht-linearen Fall die Verlustausbreitung dem Ansatz **P_{dyn} = C_{dyn} · f^{x}** folgt, müssen in diesem Fall zunächst der Koeffizient C_{dyn} und der Exponent x der Potenzfunktion nach einem bestimmten Verfahren ermittelt werden (Schritt 208). Somit lässt sich der dynamische Verlustwiderstand R_{dyn} auch im Falle einer nicht-linearen Ausbreitung physikalisch begründet in ein Netzwerkelement umwandeln (Schritte 209 und 210). Die Grundlagen für diesen Ansatz bilden umfangreiche Messungen der Verlustausbreitung im Labor.

Die Hauptinduktivität in ihrem zeitlichen Verlauf (Hysteresekurve) kann aus der Differenz des gesamten Magnetisierungsstroms und den ohmschen Strömen durch die berechneten Widerstände R_{dyn} und Rₛₜₐₜ ermittelt werden (Schritt 211).

Von dem Modell werden schließlich die Magnetisierungsstrom/Spannung-Kennlinie sowie die Information über den Phasenwinkel der Hauptimpedanz bei unterschiedlichen Kernspannungen in entsprechende Informationen bei Betriebsfrequenz bzw. im Betriebsfall umgesetzt (Schritt 212) und als Daten zur weiteren Verarbeitung durch das in Fig. 5 gezeigte Verfahren übergeben.

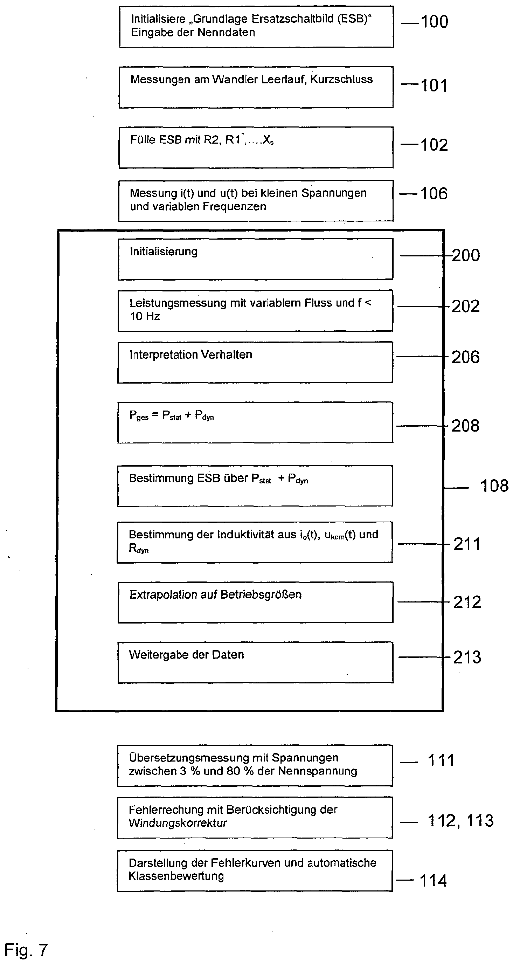

Fig. 7 zeigt ein Flussdiagramm eins alternativen Verfahrens zu Fig. 5 und Fig. 6 unter Anwendung eines ferromagnetischen Verlustmodells oder Simulationsmodells gemäß einem weiteren Ausführungsbeispiel der Erfindung, wobei bei diesem Ausführungsbeispiel auf die Bestimmung der primären Wicklungskapazität Cp verzichtet wird. Dabei sind in Fig. 7 die den in Fig. 5 und Fig. 6 gezeigten Schritten entsprechenden Schritte mit denselben Bezugszeichen versehen, so dass diesbezüglich auf die vorhergehende Beschreibung dieser Schritte verwiesen werden kann.

Das in Fig. 7 dargestellte Verfahren unterscheidet sich von den in Fig. 5 und Fig. 6 dargestellten Verfahren im Wesentlichen einerseits darin, dass diejenigen Schritte, welche die Bestimmung und Berücksichtigung der primären Wicklungskapazität Cp betreffen, entfallen, und andererseits in der alternativen Ausgestaltung beziehungsweise Formulierung des ferromagnetischen Verlustmodells 108.

Nach dem Schritt 206 werden die bei den Leistungsmessungen auftretenden Verluste P_{ges} wieder mit einem Verlust-Separationsansatz in statische Verluste Pₛₜₐₜ und dynamische Verluste P_{dyn} getrennt, um auf dieser Grundlage die Elemente des Ersatzschaltbilds zu bestimmen. Im Schritt 211 wird die Hauptinduktivität aus i₀(t), uₖₑᵣₙ(t) und dem (auch als R_{eddy} bezeichneten) dynamischen Widerstand R_{dyn} ermittelt.

Wie in Fig. 7 angedeutet, wird die Übersetzungsmessung im Schritt 111 vorzugsweise mit Spannungen im Bereich von 3% bis 80% der Nennspannung des Prüflings durchgeführt.

Die zuvor anhand von Fig. 6 und Fig. 7 erläuterten Verlustinterpretationsmodelle sind lediglich beispielhaft zu verstehen, wobei auch andere Modelle zur Anwendung gelangen können. Da bei den im Zusammenhang mit Fig. 5 beschriebenen Messungen vorzugsweise Spannungen und Frequenzen verwendet werden, welche deutlich unter den entsprechenden Nennwerten des zu prüfenden Spannungswandlers liegen, hat das verwendete Modell primär die Aufgabe, die von den Nennwerten abweichenden Messdaten auf Daten umzurechnen, welche auf die Nennwerte bezogen sind. Dabei ist zum einen die Magnetisierungskurve des Spannungswandlers zu erfassen, wobei der Kern des Spannungswandlers vorzugsweise von der Sekundärseite durch Anlegen einer geeigneten Spannung unterhalb der Nennfrequenz in die Sättigung getrieben wird. Zum anderen sind die frequenzabhängigen Verluste des Spannungswandlers zu erfassen, damit diese dann mit den richtigen Faktoren wieder auf die Nennwerte umgerechnet werden können. Wie die jeweiligen Parameter gemessen und umgerechnet werden, hängt von dem jeweils verwendeten Modell ab.

Bestimmte Wandlertypen verfügen über eine angeschlossene Dämpfungseinheit. Diese Dämpfungseinheit kann bei der Bestimmung der Genauigkeit des Wandlers mitberücksichtigt werden, um die Aussagekraft der Prüfung der Genauigkeit des Wandlers zu verbessern.

## Patentansprüche

1. Verfahren zum Testen eines Spannungswandlers (20), umfassend die Schritte
a) Nachbilden des Spannungswandlers (20) durch ein Ersatzschaltbild (30),
b) Anlegen eines Testsignals an den Spannungswandler (20),
c) Erfassen einer Testantwort des Spannungswandlers (20) in Abhängigkeit von dem Testsignal und automatisches Bestimmen von Werten für Komponenten des Ersatzschaltbildes (30) in Abhängigkeit von der Testantwort des Spannungswandlers (20),
d) automatisches Bestimmen einer auf das Ersatzschaltbild (30) bezogenen Genauigkeit des Spannungswandlers (20) auf Grundlage der Testantwort und auf Grundlage des somit mit den bestimmten Werten für die Komponenten belegten Ersatzschaltbildes (30), und
e) automatisches Bestimmen einer auf einen Betriebsfall bezogenen Genauigkeit des Spannungswandlers (20) aus der auf das Ersatzschaltbild (30) bezogenen Genauigkeit,
wobei im Schritt d) eine auf das Ersatzschaltbild (30) bezogene Spannungsabweichung und/oder ein auf das Ersatzschaltbild (30) bezogener Fehlwinkel des Spannungswandlers (20) für verschiedene Bürden, Betriebsspannungen und/oder Betriebsfrequenzen des Spannungswandlers (20) bestimmt und im Schritt e) in eine entsprechende Spannungsabweichung beziehungsweise einen entsprechenden Fehlwinkel für entsprechende Betriebsfälle des Spannungswandlers (20) umgesetzt werden.

2. Verfahren nach Anspruch 1,
**dadurch gekennzeichnet,**
**dass** im Schritt e) die auf das Ersatzschaltbild (30) bezogene Genauigkeit des Spannungswandlers (20) unter Verwendung eines Simulationsmodells des Spannungswandlers (20) in die auf den Betriebsfall bezogene Genauigkeit des Spannungswandlers (20) umgesetzt wird, wobei das Simulationsmodell frequenzabhängige und flussabhängige Eisenverluste des Spannungswandlers (20) berücksichtigt.

3. Verfahren nach einem der vorhergehenden Ansprüche,
**dadurch gekennzeichnet,**
**dass** zur Bestimmung der auf das Ersatzschaltbild (30) bezogenen Genauigkeit des Spannungswandlers (20) ein Testsignal mit einer Spannung von maximal 10V und/oder einer Frequenz von maximal 10Hz angelegt wird.

4. Verfahren nach einem der vorhergehenden Ansprüche,
**dadurch gekennzeichnet,**
**dass** zur Bestimmung der auf das Ersatzschaltbild (30) bezogenen Genauigkeit des Spannungswandlers (20) ein Testsignal mit einer Spannung kleiner als die Nennspannung des Spannungswandlers (20) und einer Frequenz kleiner als die Nennfrequenz des Spannungswandlers (20) angelegt wird.

5. Verfahren nach einem der vorhergehenden Ansprüche,
**dadurch gekennzeichnet,**
**dass** in den Schritten b)-d) durch eine Widerstandsmessung an dem Spannungswandler (20) ein Primärwicklungswiderstand und ein Sekundärwicklungswiderstand des Ersatzschaltbilds (30) bestimmt werden.

6. Verfahren nach Anspruch 5,
**dadurch gekennzeichnet,**
**dass** eine Widerstandsmessung an jeder Sekundärwicklung des Spannungswandlers (20) durchgeführt wird, um für jede Sekundärwicklung den entsprechenden Sekundärwicklungswiderstand zu bestimmen, wobei aus den bestimmten Sekundärwicklungswiderständen und aus gemessenen Streuverlusten des Spannungswandlers (20) automatisch ein transformierter Primärwicklungswiderstand des Ersatzschaltbilds (30) bestimmt wird.

7. Verfahren nach einem der vorhergehenden Ansprüche,
**dadurch gekennzeichnet,**
**dass** in den Schritten b)-d) durch eine Kurzschlussimpedanzmessung Streuverluste des Spannungswandlers (20) automatisch bestimmt werden.

8. Verfahren nach Anspruch 7,
**dadurch gekennzeichnet,**
**dass** zur Bestimmung der Streuverluste der Spannungswandler (20) primärseitig kurzgeschlossen wird und ein Testsignal nacheinander an jede Sekundärwicklung des Spannungswandlers (20) angelegt wird

9. Verfahren nach einem der vorhergehenden Ansprüche,
**dadurch gekennzeichnet,**
**dass** in den Schritten b)-d) durch primärseitige und sekundärseitige Kurzschlussimpedanzmessungen Streuinduktivitäten des Ersatzschaltbilds (30) des Spannungswandlers (20) automatisch bestimmt werden.

10. Verfahren nach einem der vorhergehenden Ansprüche,
**dadurch gekennzeichnet,**
**dass** in den Schritten b)-d) eine Messung des Magnetisierungsverhaltens des Spannungswandlers (20) durch Anlegen von Testsignalen mit unterschiedlichen Spannungen und Frequenzen durchgeführt wird.

11. Verfahren nach einem der vorhergehenden Ansprüche,
**dadurch gekennzeichnet,**
**dass** in den Schritten b)-d) eine Bestimmung des Übersetzungsverhältnisses des Spannungswandlers (20) durchgeführt wird.

12. Verfahren nach Anspruch 11,
**dadurch gekennzeichnet,**
**dass** zur Bestimmung des Übersetzungsverhältnisses ein Testsignal mit einer Spannung im Bereich von 3% bis 80% der Nennspannung des Spannungswandlers (20) primärseitig an den Spannungswandler (20) angelegt wird.

13. Verfahren nach Anspruch 11 oder Anspruch 12,
**dadurch gekennzeichnet,**
**dass** eine Messung eines Gesamtübersetzungsverhältnisses des Spannungswandlers (20), eine Messung eines Übersetzungsverhältnisses eines induktiven Spannungswandlers des Spannungswandler (20) und eine Messung eines Übersetzungsverhältnisses eines kapazitiven Spannungsteilers des Spannungswandlers (20) durchgeführt wird.

14. Verfahren nach einem der vorhergehenden Ansprüche,
**dadurch gekennzeichnet,**
**dass** bei der Bestimmung der Genauigkeit des Spannungswandlers (20) eine während der Herstellung des Spannungswandlers (20) durchgeführter Windungsabgleich automatisch berücksichtigt wird.

15. Verfahren nach Anspruch 14 und einem der Ansprüche 11-13,
**dadurch gekennzeichnet,**
**dass** der Windungsabgleich bei der Bestimmung des Übersetzungsverhältnisses des Spannungswandlers (20) berücksichtigt wird.

16. Verfahren nach einem der vorhergehenden Ansprüche,
**dadurch gekennzeichnet,**
**dass** die Testantwort durch Anwendung eines Vierdraht-Messverfahrens erfasst wird.

17. Verfahren nach einem der vorhergehenden Ansprüche,
**dadurch gekennzeichnet,**
**dass** das Verfahren für einen als induktiven Spannungswandler ausgestalteten Spannungswandler (20) oder für einen als kapazitiven Spannungswandler ausgestatteten Spannungswandler (20) durchgeführt wird.

18. Verfahren nach einem der vorhergehenden Ansprüche,
**dadurch gekennzeichnet,**
**dass** das Verfahren mit Hilfe eines tragbaren Testgeräts (10) am Installationsort des Spannungswandlers (20) durchgeführt wird.

19. Vorrichtung (10) zum Testen eines Spannungswandlers (20), umfassend eine Testsignalquelle (11) zum Erzeugen eines an den Spannungswandler (20) anzulegenden Testsignals,
eine Testantwort-Erfassungseinrichtung (13) zum Erfassen einer Testantwort des Spannungswandlers (20) in Abhängigkeit von dem Testsignal, und
eine Auswertungseinrichtung (14), welche derart ausgestaltet ist, dass sie den Spannungswandler durch ein Ersatzschaltbild (30) nachbildet und automatisch Werte für Komponenten des Ersatzschaltbildes (30) in Abhängigkeit von der Testantwort des Spannungswandlers (20) bestimmt, um auf Grundlage der Testantwort und auf Grundlage des somit mit den bestimmten Werten für die Komponenten belegten Ersatzschaltbildes (30) automatisch eine auf das Ersatzschaltbild (30) bezogene Genauigkeit des Spannungswandlers (20) zu bestimmen und diese in eine auf einen Betriebsfall bezogenen Genauigkeit des Spannungswandlers (20) umzusetzen, wobei die Auswertungseinrichtung (14) dabei eine auf das Ersatzschaltbild (30) bezogene Spannungsabweichung und/oder einen- auf das Ersatzschaltbild (30) bezogenen Fehlwinkel des Spannungswandlers (20) für verschiedene Bürden, Betriebsspannungen und/oder Betriebsfrequenzen des Spannungswandlers (20) bestimmt und in eine entsprechende Spannungsabweichung beziehungsweise einen entsprechenden Fehlwinkel für entsprechende Betriebsfälle des Spannungswandlers (20) umsetzt.

20. Vorrichtung nach Anspruch 19,
**dadurch gekennzeichnet,**
**dass** die Vorrichtung (20) als ein tragbares Testgerät zur Durchführung eines in-situ-Tests des Spannungswandlers (20) ausgestaltet ist.

21. Vorrichtung nach einem der Ansprüche 19-20,
**dadurch gekennzeichnet,**
**dass** die Vorrichtung zur Durchführung des Verfahrens nach einem der Ansprüche 1-18 ausgestaltet ist.

## Claims

1. Method for testing a voltage transformer (20), comprising the steps
a) emulating the voltage transformer (20) by means of an equivalent circuit (30),
b) applying a test signal to the voltage transformer (20),
c) detecting a test response of the voltage transformer (20) in dependence on the test signal and automatically determining values for components of the equivalent circuit (30) in dependence on the test response of the voltage transformer (20),
d) automatically determining an equivalent-circuit (30)-related accuracy of the voltage transformer (20) on the basis of the test response and on the basis of equivalent circuit (30) thus provided with the values for the components, and
e) automatically determining an operating-condition-related accuracy of the voltage transformer (20) from the equivalent-circuit (30)-related accuracy,
wherein in step d), an equivalent-circuit (30)-related voltage deviation and/or an equivalent-circuit (30)-related phase displacement of the voltage transformer (20) are determined for different burdens, operating voltages and/or operating frequencies of the voltage transformer (20), and are converted in step e) into a corresponding voltage deviation or a corresponding phase displacement for corresponding operating conditions of the voltage transformer (20).

2. Method according to claim 1,
**characterised in that**
in step e), the equivalent-circuit (30)-related accuracy of the voltage transformer (20) is converted into the operating-condition-related accuracy of the voltage transformer (20) using a simulation model of the voltage transformer (20), wherein the simulation model takes into consideration frequency-dependent and flux-dependent iron losses of the voltage transformer (20).

3. Method according to any one of the preceding claims,
**characterised in that**
for determining the equivalent-circuit (30)-related accuracy of the voltage transformer (20), a test signal with a voltage of not more than 10 V and/or a frequency of not more than 10 Hz is applied.

4. Method according to any one of the preceding claims,
**characterised in that**
for determining the equivalent-circuit (30)-related accuracy of the voltage transformer (20), a test signal with a voltage less than the nominal voltage of the voltage transformer (20) and a frequency less than the nominal frequency of the voltage transformer (20) is applied.

5. Method according to any one of the preceding claims,
**characterised in that**
in steps b) to d), a primary winding resistance and a secondary winding resistance of the equivalent circuit (30) are determined by means of a resistance measurement on the voltage transformer (20).

6. Method according to claim 5,
**characterised in that**
a resistance measurement is carried out at each secondary winding of the voltage transformer (20) in order to determine the corresponding secondary winding resistance for each secondary winding, wherein a transformed primary winding resistance of the equivalent circuit (30) is determined automatically from the determined secondary winding resistances and from measured stray losses of the voltage transformer (20).

7. Method according to any one of the preceding claims,
**characterised in that**
in steps b) to d), stray losses of the voltage transformer (20) are determined automatically by a short-circuit impedance measurement.

8. Method according to claim 7,
**characterised in that**
for determining the stray losses of the voltage transformer (20), the primary side is short circuited and a test signal is applied to each secondary winding of the voltage transformer (20) in succession.

9. Method according to any one of the preceding claims,
**characterised in that**
in steps b) to d), leakage inductances of the equivalent circuit (30) of the voltage transformer (20) are determined automatically by short-circuit impedance measurements on the primary side and on the secondary side.

10. Method according to any one of the preceding claims,
**characterised in that**
in steps b) to d), a measurement of the magnetisation behaviour of the voltage transformer (20) is carried out by applying test signals with different voltages and frequencies.

11. Method according to any one of the preceding claims,
**characterised in that**
in steps b) to d), the transformation ratio of the voltage transformer (20) is determined.

12. Method according to claim 11,
**characterised in that**
for determining the transformation ratio, a test signal with a voltage in the range of from 3% to 80% of the nominal voltage of the voltage transformer (20) is applied to the voltage transformer (20) on the primary side.

13. Method according to claim 11 or claim 12,
**characterised in that**
a measurement of a total transformation ratio of the voltage transformer (20), a measurement of a transformation ratio of an inductive voltage transformer of the voltage transformer (20) and a measurement of a transformation ratio of a capacitive voltage divider of the voltage transformer (20) are carried out.

14. Method according to any one of the preceding claims,
**characterised in that**
when determining the accuracy of the voltage transformer (20), a winding adjustment carried out during the manufacture of the voltage transformer (20) is automatically taken into consideration.

15. Method according to claim 14 and any one of claims 11-13,
**characterised in that**
the winding adjustment is taken into consideration when determining the transformation ratio of the voltage transformer (20).

16. Method according to any one of the preceding claims,
**characterised in that**
the test response is detected using a four-wire measuring method.

17. Method according to any one of the preceding claims,
**characterised in that**
the method is carried out for a voltage transformer (20) in the form of an inductive voltage transformer or for a voltage transformer (20) in the form of a capacitive voltage transformer.

18. Method according to any one of the preceding claims,
**characterised in that**
the method is carried out by means of a portable test device (10) at the installation site of the voltage transformer (20).

19. Device (10) for testing a voltage transformer (20), comprising
a test signal source (11) for generating a test signal which is to be applied to the voltage transformer (20),
a test response detecting device (13) for detecting a test response of the voltage transformer (20) in dependence on the test signal, and
an evaluation device (14) which is so configured that it emulates the voltage transformer by an equivalent circuit (30) and automatically determines values for components of the equivalent circuit (30) in dependence on the test response of the voltage transformer (20) in order to automatically determine an equivalent-circuit (30)-related accuracy of the voltage transformer (20) on the basis of the test response and on the basis of equivalent circuit (30) thus provided with the values for the components and to convert the equivalent-circuit (30)-related accuracy into an operating-condition-related accuracy of the voltage transformer (20), wherein the evaluation device (14) determines an equivalent-circuit (30)-related voltage deviation and/or an equivalent-circuit (30)-related phase displacement of the voltage transformer (20) for different burdens, operating voltages and/or operating frequencies of the voltage transformer (20) and converts these into a corresponding voltage deviation or a corresponding phase displacement for corresponding operating conditions of the voltage transformer (20).

20. Device according to claim 19,
**characterised in that**
the device (10) is in the form of a portable test device for carrying out an in situ test of the voltage transformer (20).

21. Device according to any one of claims 19-20,
**characterised in that**
the device is configured for carrying out the method according to any one of claims 1 to 18.

## Revendications

1. Procédé de test d'un transformateur de tension (20) comprenant les étapes consistant à
a) reproduire le transformateur de tension (20) par un schéma de circuit équivalent (30),
b) appliquer un signal de test au transformateur de tension (20),
c) détecter une réponse de test du transformateur de tension (20) en fonction du signal de test et déterminer automatiquement des valeurs de composantes du schéma de circuit équivalent (30) en fonction de la réponse de test du transformateur de tension (20),
d) déterminer automatiquement une précision du transformateur de tension (20) par rapport au schéma de circuit équivalent (30) sur la base de la réponse de test et sur la base du schéma de circuit équivalent (30) ainsi associé aux valeurs déterminées des composantes, et
e) déterminer automatiquement une précision du transformateur de tension (20) par rapport à une situation de fonctionnement à partir de la précision par rapport au schéma de circuit équivalent (30),
dans lequel à l'étape d), un écart de tension par rapport au schéma de circuit équivalent (30) et/ou une erreur d'angle du transformateur de tension (20) par rapport au schéma de circuit équivalent (30) détermine, pour différentes charges, des tensions de fonctionnement et/ou des fréquences de fonctionnement du transformateur de tension (20) et, à l'étape e), sont convertis en un écart de tension correspondant ou en une erreur d'angle correspondante pour des situations de fonctionnement correspondantes du transformateur de tension (20).

2. Procédé selon la revendication 1,
**caractérisé en ce que**,
à l'étape e), la précision du transformateur de tension (20) par rapport au schéma de circuit équivalent (30) est convertie en précision du transformateur de tension (20) par rapport à la situation de fonctionnement en utilisant un modèle de simulation du transformateur de tension (20), dans lequel le modèle de simulation prend en compte des pertes en fer dépendantes de la fréquence et du flux du transformateur de tension (20).

3. Procédé selon l'une quelconque des revendications précédentes,
**caractérisé en ce que**
un signal de test avec une tension maximum de 10 V et/ou une fréquence maximum de 10Hz est appliqué pour déterminer la précision du transformateur de tension (20) par rapport au schéma de circuit équivalent (30).

4. Procédé selon l'une quelconque des revendications précédentes,
**caractérisé en ce que**
un signal de test avec une tension inférieure à la tension nominale du transformateur de tension (20) et une fréquence inférieure à la fréquence nominale du transformateur de tension (20) est appliqué pour déterminer la précision du transformateur de tension (20) par rapport au schéma de circuit équivalent (30).

5. Procédé selon l'une quelconque des revendications précédentes,
**caractérisé en ce que**
dans les étapes b) à d), une résistance d'enroulement primaire et une résistance d'enroulement secondaire du schéma de circuit équivalent (30) sont déterminées par une mesure de résistance au niveau du transformateur de tension (20).

6. Procédé selon la revendication 5,
**caractérisé en ce que**
une mesure de résistance est effectuée sur chaque enroulement secondaire du transformateur de tension (20), afin de déterminer pour chaque enroulement secondaire la résistance d'enroulement secondaire correspondante, dans lequel une résistance d'enroulement primaire transformée du schéma de circuit équivalent (30) est déterminée automatiquement à partir des résistances d'enroulement secondaire déterminées et des fuites mesurées du transformateur de tension (20).

7. Procédé selon l'une quelconque des revendications précédentes,
**caractérisé en ce que**
dans les étapes b) à d), des fuites du transformateur de tension (20) sont déterminées automatiquement par une mesure d'impédance de court-circuit.

8. Procédé selon la revendication 7,
**caractérisé en ce que**
pour déterminer les fuites, le transformateur de tension (20) est court-circuité côté primaire et un signal de test est appliqué successivement à chaque enroulement secondaire du transformateur de tension (20).

9. Procédé selon l'une quelconque des revendications précédentes,
**caractérisé en ce que**
dans les étapes b) à d), des inductances de fuite du schéma de circuit équivalent (30) du transformateur de tension (20) sont déterminées automatiquement par des mesures d'impédance de court-circuit côté primaire et côté secondaire.

10. Procédé selon l'une quelconque des revendications précédentes,
**caractérisé en ce que**
dans les étapes b) à d), une mesure du comportement de magnétisation du transformateur de tension (20) est effectuée en appliquant des signaux de test avec différentes tensions et différentes fréquences.

11. Procédé selon l'une quelconque des revendications précédentes,
**caractérisé en ce que**
dans les étapes b) à d) une détermination du rapport de démultiplication du transformateur de tension (20) est effectuée.

12. Procédé selon la revendication 11,
**caractérisé en ce que**
pour déterminer le rapport de démultiplication, un signal de test avec une tension dans la plage de 3 % à 80 % de la tension nominale du transformateur de tension (20) est appliqué côté primaire sur le transformateur de tension (20).

13. Procédé selon la revendication 11 ou la revendication 12
**caractérisé en ce que**
une mesure d'un rapport de démultiplication total du transformateur de tension (20), une mesure d'un rapport de démultiplication d'un transformateur de tension inductif du transformateur de tension (20) et une mesure d'un rapport de démultiplication d'un diviseur de tension capacitif du transformateur de tension (20) sont effectuées.

14. Procédé selon l'une quelconque des revendications précédentes,
**caractérisé en ce que**
lors de la détermination de la précision du transformateur de tension (20), une compensation d'enroulement effectuée pendant la réalisation du transformateur de tension (20) est automatiquement prise en compte.

15. Procédé selon la revendication 14 et l'une quelconque des revendications 11 à 13,
**caractérisé en ce que**
la compensation d'enroulement est prise en compte lors de la détermination du rapport de démultiplication du transformateur de tension (20).

16. Procédé selon l'une quelconque des revendications précédentes,
**caractérisé en ce que**
la réponse de test est détectée par l'application d'un procédé de mesure à quatre fils.

17. Procédé selon l'une quelconque des revendications précédentes,
**caractérisé en ce que**
le procédé est effectué pour un transformateur de tension (20) conçu sous la forme d'un transformateur de tension inductif ou pour un transformateur de tension (20) conçu sous la forme d'un transformateur de tension capacitif.

18. Procédé selon l'une quelconque des revendications précédentes,
**caractérisé en ce que**
le procédé est effectué à l'aide d'un appareil de test portable (10) sur le site d'installation du transformateur de tension (20).

19. Dispositif (10) pour tester un transformateur de tension (20), comprenant une source de signal de test (11) pour générer un signal de test à appliquer au transformateur de tension (20),
un dispositif de détection de réponse de test (13) destiné à détecter une réponse de test du transformateur de tension (20) en fonction du signal de test, et
un dispositif d'évaluation (14) qui est conçu de manière à reproduire le transformateur de tension au moyen d'un schéma de circuit équivalent (30) et détermine automatiquement des valeurs pour des composantes du schéma de circuit équivalent (30) en fonction de la réponse de test du transformateur de tension (20) pour, sur la base de la réponse de test et du schéma de circuit équivalent (30) étayé par les valeurs déterminées pour les composantes, déterminer automatiquement une précision du transformateur de tension (20) par rapport au schéma de circuit équivalent (30) et la convertit dans une précision du transformateur de tension (20) par rapport à une situation de fonctionnement, dans lequel le dispositif d'évaluation (14) détermine ainsi un écart de tension par rapport au schéma de circuit équivalent (30) et/ou une erreur d'angle du transformateur de tension (20) par rapport au schéma de circuit équivalent (30) pour différentes charges, des tensions de fonctionnement et/ou des fréquences de fonctionnement du transformateur de tension (20), et convertit en un écart de tension correspondant ou en une erreur d'angle correspondante pour des situations de fonctionnement correspondantes du transformateur de tension (20).

20. Dispositif selon la revendication 19,
**caractérisé en ce que**
le dispositif (20) est conçu sous la forme d'un appareil de test portable pour effectuer un test in situ du transformateur de tension (20).

21. Dispositif selon l'une quelconque des revendications 19 à 20,
**caractérisé en ce que**
le dispositif est conçu pour mettre en oeuvre le procédé selon l'une des revendications 1 à 18.
